# EUROPÄISCHE PATENTSCHRIFT

(11) **EP 1 812 971 B1**
(45) Veröffentlichungstag und Bekanntmachung des Hinweises auf die Patenterteilung: **15.01.2020**
(21) Anmeldenummer: 05801556.1
(22) Anmeldetag: 21.10.2005
(51) Int. Cl.: H01L 29/872, H01L 29/861, H01L 21/329, H01L 29/866

(54) **HALBLEITEREINRICHTUNG UND VERFAHREN FÜR DEREN HERSTELLUNG**
SEMICONDUCTOR DEVICE AND METHOD FOR PRODUCING THE SAME
DISPOSITIF A SEMICONDUCTEURS ET PROCEDE DE FABRICATION

(30) Priorität: 08.11.2004 DE 102004053761
(43) Veröffentlichungstag der Anmeldung: 01.08.2007
(73) Patentinhaber: ROBERT BOSCH GMBH, 70442 Stuttgart (DE)
(72) Erfinder: GOERLACH, Alfred, 72127 Kusterdingen (DE); QU, Ning, 72770 Reutlingen (DE)
(86) Internationale Anmeldenummer: PCT/EP2005/055463
(87) Internationale Veröffentlichungsnummer: WO 2006/048387

(56) Entgegenhaltungen:
- EP-A- 1 139 433
- EP-A- 1 369 927
- US-A- 4 982 260
- US-A- 5 081 509
- US-A- 5 241 195
- US-A- 6 078 090
- US-A1- 2001 000 033
- US-A1- 2002 008 237
- US-A1- 2004 061 195
- US-B1- 6 590 240

## Beschreibung

### Stand der Technik

Die Erfindung betrifft eine Halbleitereinrichtung nach dem Oberbegriff des Anspruchs 1, sowie Verfahren für deren Herstellung. Bei der Halbleitereinrichtung der gattungsgemäßen Art handelt es sich um eine Junction-Barrier-Schottky-Diode, die über eine Grabenstruktur verfügt. Die Halbleitereinrichtung eignet sich besonders gut als Z-Diode (Zener-Diode) für den Einsatz in dem Bordnetz eines Kraftfahrzeugs.

In modernen Kraftfahrzeugen werden immer mehr Funktionen mit elektrischen Bauelementen realisiert. Dadurch entsteht ein immer höherer Bedarf an elektrischer Leistung. Um diesen Bedarf zu decken, muss die Effizienz des Generatorsystems in dem Kraftfahrzeug gesteigert werden. Bis heute werden in der Regel PN-Dioden als Z-Dioden in dem Generatorsystem des Kraftfahrzeugs eingesetzt. Vorteile der PN-Dioden sind einerseits der niedrige Sperrstrom und andererseits die hohe Robustheit. Der Hauptnachteil ist jedoch die vergleichsweise hohe Flussspannung UF. Bei Raumtemperatur beginnt Strom erst bei einer Flussspannung UF von etwa 0,7 V zu fließen. Unter normalen Betriebsbedingungen, bei denen die Stromdichte etwa 500A/cm2 beträgt, steigt die Flussspannung UF bis über 1V an. Dies führt zu einem Rückgang der Effizienz.

Aufgrund theoretischer Überlegungen könnte die Schottky-Diode als Alternative in Betracht gezogen werden. Eine Schottky-Diode hat nämlich eine deutlich niedrigere Flussspannung als eine PN-Diode. Beispielsweise beträgt die Flussspannung einer Schottky-Diode etwa 0.5V bis 0.6V bei einer Stromdichte von etwa 500A/cm2. Außerdem bietet eine Schottky-Diode als Majoritätsträgerbauelement Vorteile bei schnellem Schaltbetrieb. Soweit bekannt, ist jedoch der Einsatz von Schottky-Dioden in dem Generatorsystem eines Kraftfahrzeugs bisher noch nicht erfolgt. Dies mag auf einige entscheidende Nachteile einer Schottky-Diode zurückzuführen sein, die eine derartige Anwendung eher als ferner liegend erscheinen lassen. Zunächst hat eine Schottky-Diode im Vergleich zu einer PN-Diode einen höheren Sperrstrom. Dieser Sperrstrom ist weiterhin stark abhängig von der Sperrspannung. Schließlich zeigt eine Schottky-Diode eine schlechtere Robustheit, insbesondere bei hohen Temperaturen. Diese Nachteile haben bisher den Einsatz von Schottky-Dioden bei Anwendungen im Kraftfahrzeug verhindert.

Aus T. Sakai, et al, "Experimental investigation of dependence of electrical characteristics on device parameters in Trench MOS Barrier Schottky Diodes", Proceedings of 1998 International Symposium on Power Semiconductors & ICs, Kyoto, pp. 293-296, S. Kunori, et al, "Low leakage current Schottky barrier diode", Proceedings of 1992 International Symposium on Power Semiconductors & ICs, Tokyo, pp. 80-85,
sowie aus DE 19 749 195 A1 sind bereits Maßnahmen für eine Verbesserung der Eigenschaften von Schottky-Dioden bekannt, die zu der so genannten JBS (JBS = Junction-Barrier-Schottky-Diode) oder der so genannten TMBS (TMBS = Trench-MOS-Barrier-Schottky-Diode) geführt haben. Bei der JBS kann durch geeignete Bemessung bestimmter Strukturparameter der für einen hohen Sperrstrom verantwortliche Schottky-Effekt wenigstens teilweise abgeschirmt und dadurch der Sperrstrom reduziert werden. Eine noch weitergehende Abschirmung etwa durch eine noch tiefere p-Diffusion ist allerdings nicht praktikabel, da gleichzeitig auch das Diffusionsgebiet in lateraler Richtung weiter ausgedehnt würde. Dadurch würde aber in nachteiliger Weise die für einen Stromfluss in Flussrichtung zur Verfügung stehende Fläche weiter reduziert werden. Der Vorteil einer TMBS liegt in der möglichen Reduktion des Sperrstroms. Der Sperrstrom fließt dabei hauptsächlich durch eine Quasi-Inversionsschicht der MOS-Struktur der Diode entlang der Oberfläche eines in die Diodenstruktur eingebrachten Grabens. Als Folge davon kann die MOS-Struktur durch die Injektion so genannter "heißer" Ladungsträger von einer n-Epischicht in eine Oxidschicht degradiert und unter besonders widrigen Bedingungen sogar zerstört werden. Da für die Bildung des Inversionskanals eine gewisse Zeit benötigt wird, kann sich die Raumladungszone zu Beginn von schnellen Schaltvorgängen kurzzeitig weiter ausbreiten und infolgedessen die elektrische Feldstärke ansteigen. Dies kann zu einem kurzzeitigen, unerwünschten Betrieb der Diode im Durchbruch führen. Es ist daher wenig ratsam, die hinsichtlich des Sperrstroms verbesserten TMBS als Z-Dioden einzusetzen und im Durchbruchsbereich zu betreiben.

Aus der US 6078090 und der EP 1139433 A1 sind bereits Schottky-Dioden mit Grabenstrukturen, in denen pn-Dioden angeordnet sind, bekannt.

### Vorteile der Erfindung

Die Erfindung mit den Merkmalen des Anspruchs 1 schlägt eine Halbleitereinrichtung mit niedriger Flussspannung, niedrigem Sperrstrom und großer Robustheit vor.

Diese bietet insbesondere den Vorteil, dass die empfindlichen Oxidschichten durch einen p-dotierten Siliziumbereich ersetzt werden und dass die Injektion von so genannten "heißen" Ladungsträgern nicht mehr auftritt. Dies wird dadurch erreicht, dass die bei einem Durchbruch auftretende hohe Feldstärke nicht in der Nähe der empfindlichen Oxidschicht liegt, weil die Durchbruchsspannung der integrierten PN-Diode niedriger ist als die Durchbruchsspannungen der Schottky-Diode und der MOS-Struktur. Die erfindungsgemäß ausgebildete Halbleitereinrichtung zeichnet sich daher durch eine besonders große Robustheit aus, die einen zuverlässigen Einsatz der Halbleitereinrichtung in dem Bordnetz eines Kraftfahrzeugs, insbesondere in dem Generatorsystem des Bordnetzes, ermöglicht. Besonders vorteilhaft ist die Halbleitereinrichtung bei Durchbruchsspannungen in der Größenordnung einiger 10V und bei Stromdichten von einigen hundert A/cm² betriebssicher einsetzbar.

Weitere Vorteile und Ausgestaltungen der Erfindung, sowie vorteilhafte Verfahren für die Herstellung der Halbleitereinrichtungen ergeben sich aus den weiteren Unteransprüchen in Verbindung mit der Beschreibung und den Zeichnungen.

### Zeichnung

Ausführungsbeispiele der Erfindung werden nachfolgend unter Bezug auf die Zeichnung näher erläutert. Dabei zeigt:
- Figur 1: eine herkömmliche Junction-Barrier-Schottky-Diode;
- Figur 2: eine herkömmliche Trench-MOS-Barrier-Schottky-Diode;
- Figur 3: ein erstes Beispiel einer Halbleitereinrichtung;
- Figur 4: ein zweites Beispiel einer Halbleitereinrichtung;
- Figur 5: ein Ausführungsbeispiel der erfindungsgemäßen Halbleitereinrichtung;
- Figur 6: ein viertes Beispiel einer Halbleitereinrichtung;
- Figur 7: ein fünftes Beispiel einer Halbleitereinrichtung;
- Figur 8: ein Ablaufdiagramm eines ersten Herstellungsverfahrens;
- Figur 9: ein Ablaufdiagramm eines zweiten Herstellungsverfahrens;
- Figur 10: ein Ablaufdiagramm eines dritten Herstellungsverfahrens;
- Figur 11: ein Ablaufdiagramm eines vierten Herstellungsverfahrens.

### Beschreibung der Ausführungsbeispiele

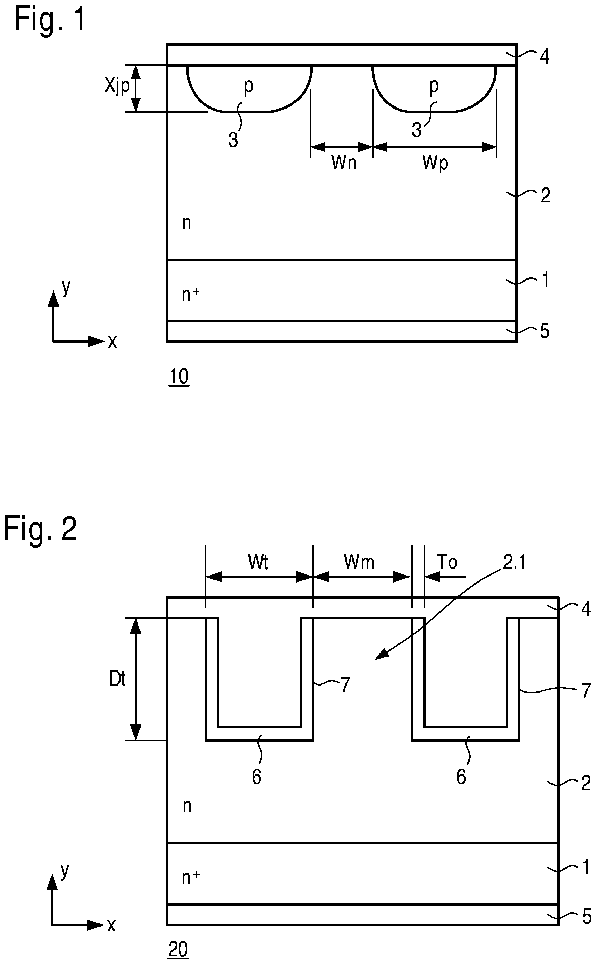

Im Folgenden werden zunächst bekannte Halbleitereinrichtungen kurz beschrieben, um die mit der Erfindung erzielbaren Vorteile besser herauszustellen. Figur 1 zeigt zunächst eine Halbleitereinrichtung 10 in Form einer herkömmlichen JBS (Junction-Barrier-Schottky-Diode), die aus einem n+-Substrat 1, einer n-Schicht 2, mindestens zwei in die n-Schicht 2 diffundierten p-Wannen 3 und Kontaktschichten 4 und 5 an der Vorderseite und an der Rückseite des Chips umfasst. Elektrisch gesehen ist die JBS eine Kombination von PN-Diode (PN-Übergang zwischen den p-Wannen 3 als Anode und der n-Schicht 2 als Kathode) und einer Schottky-Diode (Schottky-Barriere zwischen der Kontaktschicht 4 als Anode und der n-Schicht 2 als Kathode). Die Kontaktschicht 5 an der Rückseite des Chips dient als Kathodenelektrode, die Kontaktschicht 4 an der Vorderseite des Chips als Anodenelektrode mit ohmschem Kontakt zu den p-Wannen 3 und gleichzeitig als Schottky-Kontakt zu der n-Schicht 2. Wegen der kleinen Flussspannung der Schottky-Diode im Vergleich zu der PN-Diode fließt ein Strom in der Flussrichtung nur durch den Bereich der Schottky-Diode. Infolgedessen ist die effektive Fläche (pro Flächeneinheit) für den Stromfluss in Flussrichtung bei einer JBS deutlich kleiner als bei einer konventionellen Planar-Schottky-Diode. In der Sperrrichtung dehnen sich die Raumladungszonen mit steigender Spannung aus und stoßen bei einer Spannung, die kleiner als die Durchbruchspannung der JBS ist, in der Mitte des Bereichs zwischen den benachbarten p-Wannen 3 zusammen. Dadurch wird der Schottky-Effekt, der für den hohen Sperrstrom verantwortlich ist, teilweise abgeschirmt und der Sperrstrom dadurch reduziert. Dieser Abschirmeffekt ist stark von bestimmten Strukturparametern, wie Xjp (Eindringtiefe der p-Diffusion), Wn (Abstand zwischen den p-Wannen) sowie Wp (Breite der p-Wanne) abhängig. Eine übliche Technik zur Realisierung der p-Wannen einer JBS ist p-Implantation und anschließende p-Diffusion. Durch laterale Diffusion in der x-Richtung, deren Tiefe vergleichbar mit der vertikalen Diffusion in der y-Richtung ist, entstehen zylindrische p-Wannen in der zweidimensionalen Darstellung (unendliche Länge in der z-Richtung senkrecht zur x-y-Ebene), deren Radius der Eindringtiefe Xjp entspricht. Wegen der radialen Ausdehnung der Raumladungszonen zeigt diese Form von p-Wannen allerdings keine sehr wirkungsvolle Abschirmung des Schottky-Effekts. Es ist auch nicht möglich, allein durch tiefere p-Diffusion die Abschirmwirkung zu verstärken, da gleichzeitig auch die laterale Diffusion entsprechend breiter wird. Weiterhin ist auch sehr bedenklich, den Abstand Wn zwischen den p-Wannen weiter zu verkleinern. Dadurch würde zwar die Abschirmwirkung verstärkt, die effektive Fläche für den Stromfluss in Flussrichtung würde jedoch weiter reduziert.

Figur 2 zeigt ebenfalls eine bekannte Halbleitereinrichtung 20, nämlich eine so genannte TMBS-Diode, im Folgenden kurz als "TMBS" (Trench-MOS-Barrier-Schottky-Diode) bezeichnet. Zunächst wird auf den Aufbau einer derartigen TMBS eingegangen, um auch im Vergleich zu dieser Halbleitereinrichtung 20, die mit der Erfindung erzielten Vorteile deutlicher herauszustellen. Die Halbleitereinrichtung 20 besteht aus einem n⁺-Substrat 1 und einer auf diesem n⁺-Substrat angeordneten n-Schicht 2. In dieser n-Schicht 2 sind, üblicherweise auch als "trenchs" bezeichnete, Gräben 7 eingebracht. Die Grundflächen und die Wandungen der Gräben 7 sind mit einer Oxidschicht 6 abgedeckt. Eine Metallschicht 4 auf der Vorderseite der TMBS 20 dient als Anodenelektrode. Eine Metallschicht 5 auf der Rückseite der TMBS 20 dient als Kathodenelektrode. Elektrisch gesehen ist die TMBS 20 eine Kombination von MOS-Struktur (Metallschicht 4, Oxidschicht 6 und n-Schicht 2) und einer Schottky-Diode. Die Schottky-Barriere liegt dabei zwischen der Metallschicht 4 als Anode und der n-Schicht 2 als Kathode.

In der Flussrichtung fließt ein Strom durch den von den Gräben 7 eingeschlossenen Mesa-Bereich 2.1 der TMBS 20. Die Gräben 7 selber stehen für den Stromfluss nicht zur Verfügung. Die effektive Fläche für den Stromfluss in der Flussrichtung ist daher bei einer TMBS kleiner als bei einer konventionellen Planar-Schottky-Diode. Der Vorteil einer derartigen TMBS 20 liegt in der Reduktion des Sperrstroms. In der Sperrrichtung bilden sich sowohl bei der MOS-Struktur als auch bei der Schottky-Diode Raumladungszonen aus. Die Raumladungszonen dehnen sich mit steigender Spannung aus und stoßen bei einer Spannung, die kleiner als die Durchbruchspannung der TMBS 20 ist, in der Mitte des Mesa-Bereichs 2.1 zwischen den benachbarten Gräben 7 zusammen. Dadurch wird der für den hohen Sperrstrom verantwortliche Schottky-Effekt abgeschirmt und der Sperrstrom reduziert. Dieser Abschirmeffekt ist stark von Strukturparametern der TMBS, wie insbesondere Dt (Tiefe des Grabens 7), Wm (Abstand zwischen den Gräben 7), Wt (Breite des Grabens 7), sowie von To (Dicke der Oxidschicht 6) abhängig. Die Abschirmwirkung für den Schottky-Effekt ist bei der TMBS daher deutlich effektiver im Vergleich zu einer JBS mit diffundierten p-Wannen. Ein entscheidender Nachteil der bekannten TMBS liegt jedoch in der Schwäche der MOS-Struktur. Bei einem Durchbruch entstehen sehr große elektrische Felder innerhalb der Oxidschicht 6 und direkt in der Nähe der Oxidschicht 6 in der n-Schicht 2. Der Sperrstrom fließt hauptsächlich durch die Quasi-Inversionsschicht der MOS-Struktur entlang der Oberfläche der Gräben 7. Als Folge kann die MOS-Struktur durch Injektion "heißer" Ladungsträger von der n-Schicht 2 in die Oxidschicht 6 degradiert und unter bestimmten widrigen Betriebsbedingungen sogar zerstört werden. Da zur Bildung des Inversionskanals eine gewisse Zeit benötigt wird (deep depletion), kann sich die Raumladungszone zu Beginn von schnellen Schaltvorgängen kurzzeitig weiter ausbreiten und deshalb die elektrische Feldstärke weiter ansteigen. Dies kann zu einem kurzzeitigen, unerwünschten Betrieb im Durchbruch führen. Es ist daher wenig ratsam, eine TMBS als Zener-Diode einzusetzen und im Durchbruchsbereich zu betreiben.

Die Erfindung schlägt demgegenüber neuartige Halbleitereinrichtungen vor, die sich durch eine niedrige Flussspannung, einen niedrigen Sperrstrom und hohe Robustheit auszeichnen. Es handelt sich dabei um eine Junction-Barrier-Schottky-Diode (JBS) mit einer Grabenstruktur, die auch als Trench-Junction-Barrier-Schottky-Diode (TJBS) bezeichnet werden kann.

Anstatt einer p-Diffusion mit einer relativ großen Eindringtiefe (z. B. Xjp > 1 µm) wie bei einer konventionellen JBS werden die p-Wannen der TJBS durch Ätzen und anschließendes Ausfüllen der Gräben mit p-dotiertem Si bzw. Poly-Si realisiert. Als Alternative können die p-Gräben der TJBS auch durch Ätzen und anschließende Bor-Belegung in Kombination mit einer flachen Bor-Diffusion, z. B. Xjp < 0.2µm, realisiert werden. Die Durchbruchspannung BV_Pn der PN-Diode ist dabei zweckmäßig niedriger als die Durchbruchspannung BV_schottky der Schottky-Diode auszulegen. Die TJBS verfügt über hohe Stromfähigkeit in der Flussrichtung, hohe Abschirmwirkung des Schottky-Effekts in der Sperrrichtung und daher niedrigen Sperrstrom, hohe Robustheit durch Klammerfunktion der PN-Diode und Durchbruch am Boden der Gräben. Sie eignet sich daher besonders als Z-Diode für Einsatz in Kfz-Generatorsystemen.

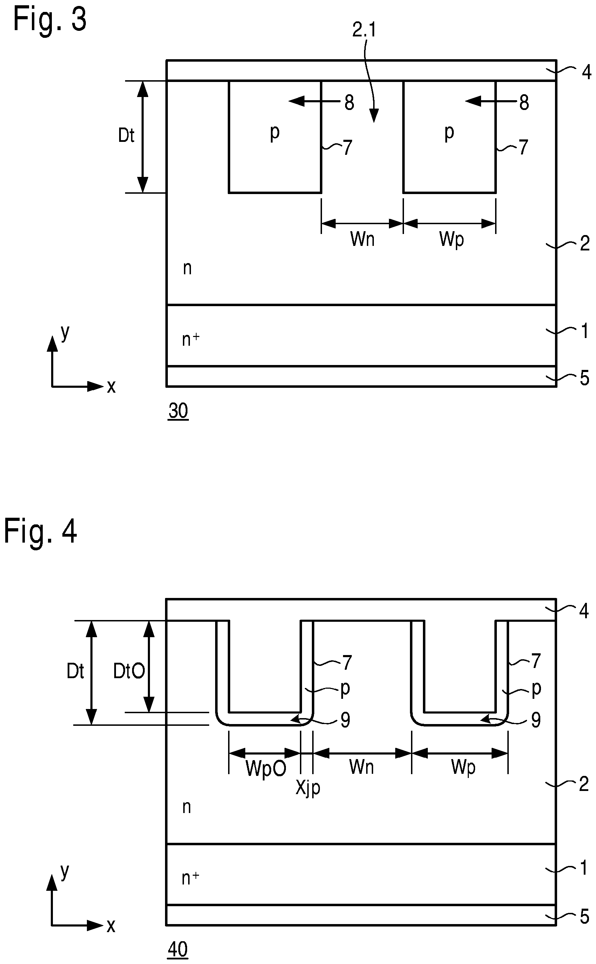

Bei einem Beispiel handelt es sich um eine Halbleitereinrichtung 30 in Gestalt einer TJBS mit ausgefüllten Gräben, die im Folgenden unter Bezug auf Figur 3 näher beschrieben wird. Wie Figur 3 zeigt, umfasst die Halbleitereinrichtung 30 ein n+-Substrat 1, eine auf diesem n+-Substrat 1 angeordnete n-Schicht 2, sowie mindestens zwei in die n-Schicht 2 eingebrachte, auch als "trenchs" bezeichnete Gräben 7. Weiterhin sind an der Vorder- und Rückseite der Halbleitereinrichtung 30 Kontaktschichten 4, 5 angeordnet, die als Anodenelektrode und Kathodenelektrode dienen. Die Gräben 7 werden vorzugsweise durch ein Ätzverfahren erzeugt. Die Kontaktschichten 4,5 bestehen vorzugsweise aus einem Metall. Insbesondere die Metallschicht 4 kann auch aus zwei unterschiedlichen, übereinander liegenden Metallschichten bestehen. Die Gräben 7 sind mit p-dotiertem Si oder Poly-Si ausgefüllt, so dass sich p-dotierte Bereiche 8 ergeben. Elektrisch gesehen ist die Halbleitereinrichtung 30 TJBS eine Kombination von PN-Diode (PN-Übergang zwischen den p-dotierten Bereichen 8 als Anode und der n-Schicht 2 als Kathode) und einer Schottky-Diode (Schottky-Barriere zwischen der Kontaktschicht 4 als Anode und der n-Schicht 2 als Kathode). Wie bei einer konventionellen Junction-Barrier-Schottky-Diode fließt der Strom in der Flussrichtung der Diode nur durch die Schottky-Diode. Wegen der fehlenden lateralen p-Diffusion ist jedoch die effektive Fläche für den Stromfluss in der Flussrichtung bei der Trench-Junction-Barrier-Schottky-Diode ähnlich wie bei der Trench-MOS-Barrier-Schottky-Diode und deutlich größer als bei einer konventionellen Junction-Barrier-Schottky-Diode. In der Sperrrichtung dehnen sich die Raumladungszonen mit steigender Spannung aus und stoßen bei einer Spannung, die kleiner als die Durchbruchspannung der Trench-Junction-Barrier-Schottky-Diode ist, in der Mitte des Bereichs zwischen den benachbarten p-Bereichen 8 zusammen. Wie bei der Junction-Barrier-Schottky-Diode wird dadurch der für einen hohen Sperrstrom verantwortliche Schottky-Effekt abgeschirmt und der Sperrstrom dadurch reduziert. Dieser Abschirmeffekt ist stark von Strukturparametern wie Dt (Tiefe der Gräben 7), Wn (Abstand zwischen den Gräben 7), sowie Wp (Breite des Grabens 7) abhängig. Zur Realisierung der Gräben 7 bei der TJBS wird auf eine p-Diffusion verzichtet. Dadurch gibt es keine negative Auswirkung von lateraler p-Diffusion wie bei einer konventionellen JBS. Eine quasi eindimensionale Ausdehnung der Raumladungszonen in dem Mesa-Bereich 2.1 zwischen den Gräben 7 kann ohne weiteres realisiert werden, da die Tiefe Dt des Grabens 7, ein wichtiger Strukturparameter für die Abschirmung des Schottky-Effekts, nicht mehr mit der effektiven Fläche für den Stromfluss in der Flussrichtung korreliert. Die Abschirmwirkung für den Schottky-Effekt ist ähnlich wie bei der TMBS und damit deutlich effektiver als bei einer herkömmlichen JBS mit diffundierten p-Wannen. Andererseits bietet die TJBS eine hohe Robustheit durch die mittels der PN-Diode jetzt gegebene Klammerfunktion. Die Durchbruchspannung BV_pn der PN-Diode wird so ausgelegt, dass sie niedriger ist als die Durchbruchspannung BV_schottky der Schottky-Diode. Weiterhin findet der Durchbruch am Boden der Gräben 7 statt. Im Durchbruchsbetrieb fließt der Sperrstrom dann nur durch den PN-Übergang der PN-Diode. Flussrichtung und Sperrrichtung sind damit geometrisch getrennt. Die TJBS verfügt damit über eine ähnliche Robustheit wie eine PN-Diode. Zur Realisierung der Halbleitereinrichtung 30 in Gestalt der TJBS wird ein abrupter PN-Übergang bevorzugt. Weiterhin wird eine Ladungskompensation wie bei einer "Cool Schottky-Diode" vermieden, da hier in erster Linie keine hoch sperrenden Dioden, sondern Z-Dioden mit einer Durchbruchspannung in der Größenordnung einiger zehn Volt, insbesondere von ca. 20V - 40V in Betracht kommen. Außerdem tritt bei der TJBS die Injektion von "heißen" Ladungsträgern nicht auf, da keine MOS-Struktur existiert. Infolgedessen ist die TJBS besonders gut als Z-Diode für den Einsatz in dem Bordnetz eines Kraftfahrzeugs, insbesondere für den Einsatz in dem Generatorsystem des Kraftfahrzeugs, geeignet.

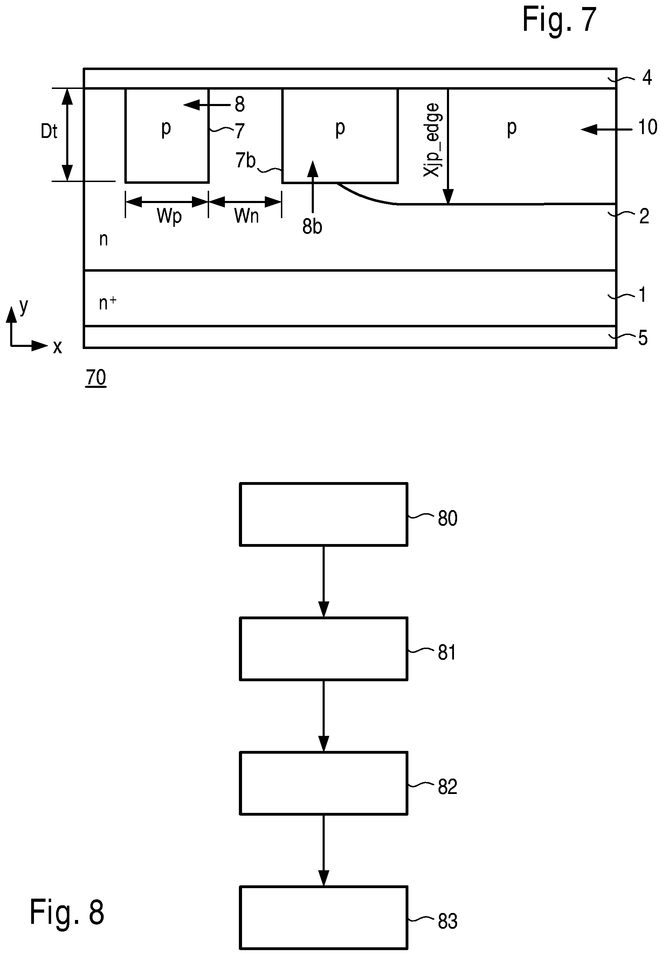

Im Folgenden wird ein vorteilhaftes Herstellungsverfahren für die Halbleitereinrichtung 30 beschrieben. In diesem Zusammenhang wird auch auf das in Figur 8 dargestellte Ablaufdiagramm verwiesen. Ausgegangen wird von einem n+-Substrat 1 (Schritt 80). Auf dieses n+-Substrat 1 wird eine n-Schicht 2 aufgebracht (Schritt 81). Dies erfolgt vorzugsweise durch ein Epitaxieverfahren. In dem nächsten Schritt 82 werden die Gräben 7 in die n-Schicht 2 geätzt. Anschließend werden die Gräben 7 mit p-dotiertem Si oder Poly-Si aufgefüllt (Schritt 83). In einem weiteren Schritt 84 werden vorzugsweise aus Metall bestehende Kontaktschichten 4 und 5 auf die Vorder- und Rückseite der Halbleitereinrichtung 30 aufgebracht.

Ein weiteres Beispiel wird im Folgenden unter Bezug auf Figur 4 beschrieben. Die in Figur 4 dargestellte Halbleitereinrichtung 40 besteht ebenfalls aus einem n+-Substrat 1, einer darauf angeordneten n-Schicht 2, sowie mindestens zwei in die n-Schicht 2 eingebrachten Gräben (Trenchs) 7. In den Gräben 7 sind die Boden und die seitenwande der Graben 7 bedeckende p-Bereiche 9 angeordnet. Weiterhin sind Kontaktschichten 4,5 an der Vorderseite des Chips einschließlich der Oberfläche der Gräben als Anodenelektrode und als Kathodenelektrode vorgesehen. Insbesondere die Kontaktschicht 4 kann vorzugsweise wiederum auch aus zwei unterschiedlichen, übereinander liegenden Metallschichten bestehen. Dabei kann der Graben 7 vollständig mit der zweiten Metallschicht ausgefüllt sein. Bei diesem Beispiel werden jedoch die p-Bereiche 9 innerhalb der Gräben 7 nicht durch Ausfüllen mit p-dotiertem Si oder Poly-Si realisiert. Vielmehr werden die p-Bereiche 9 durch Belegung der Gräben 7 mit einem p-Dotierstoff und anschließende flache Diffusion erzeugt. Als p-Dotierstoff eignet sich vorzugsweise Bor. Auch bei dieser Halbleitereinrichtung 40 soll ebenfalls ein abrupter PN-Übergang realisiert werden. Durch eine fette und sehr flache Diffusion mit einer Eindringtiefe z. B. nicht größer als 0.2 µm bei einer Grabentiefe Dt0 von ca. 1 bis 3µm, sind bei dem Beispiel gemäß Figur 4 die Abschirmwirkung des Schottky-Effekts und die Sperrfähigkeit sehr ähnlich wie beim ersten Beispiel mit ausgefüllten Gräben 7 gemäß Figur 3. Dies gilt ebenfalls für die hohe Stromfähigkeit in der Flussrichtung, die hohe Robustheit und die gute Eignung als Zener-Diode für den Einsatz in dem Bordnetz eines Kraftfahrzeugs, insbesondere für den Einsatz in dem Generatorsystem eines Kraftfahrzeugs. Ein Vorteil dieses zweiten Beispiels gegenüber dem in Figur 3 dargestellten ersten Beispiel ist die einfachere Herstellung der p-Bereiche 9 durch Belegung mit einem Dotierstoff und anschließende Diffusion im Vergleich zu dem Auffüllen der Gräben 7 mit p-dotiertem Si oder Poly-Si. Ein Nachteil dieser Variante ist jedoch die Verkleinerung der effektiven Fläche für den Stromfluss in der Flussrichtung durch die p-Diffusion mit der Eindringtiefe Xjp. Eine detaillierte Untersuchung hat jedoch ergeben, dass dieser Nachteil für eine Halbleitereinrichtung 40 mit einer Durchbruchsspannung in der Größenordnung einiger 10V praktisch zu vernachlässigen ist. Bei einer Halbleitereinrichtung 40 mit einer Durchbruchsspannung von 20V erhöht sich die Flussspannung um lediglich ca. lO mV bei Raumtemperatur und bei einer Stromdichte von etwa 500A/cm2.

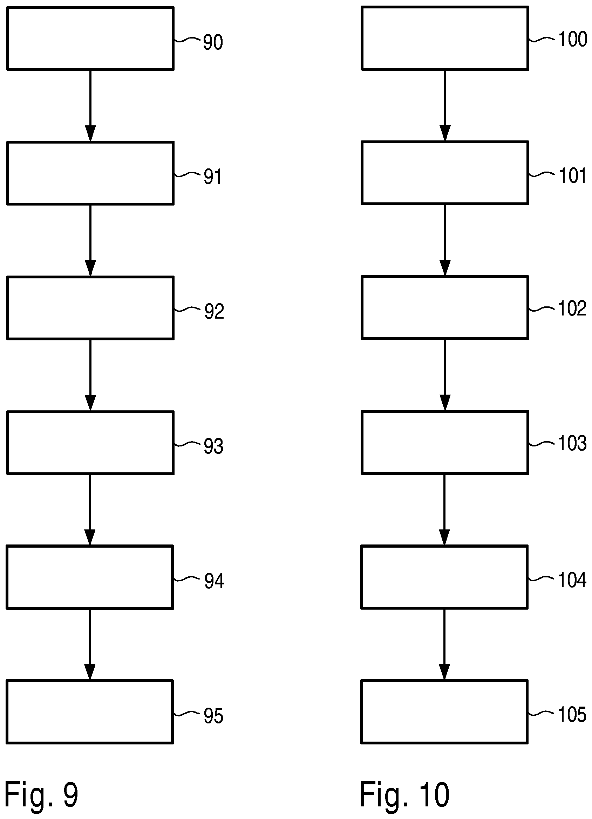

Im Folgenden wird ein vorteilhaftes Verfahren zur Herstellung der Halbleitereinrichtung 40 (Ausführungsvariante nach Figur 4) beschrieben, wobei auch auf das Ablaufdiagramm in Figur 9 Bezug genommen wird. Ausgegangen wird wiederum von einem n+-Substrat 1 (Schritt 90), auf das eine n-Schicht 2, vorzugsweise durch Epitaxie, aufgebracht wird (Schritt 91). Durch ein Ätzverfahren werden Gräben 7 in die n-Schicht 2 eingebracht (Schritt 92). Anschließend werden die Böden und Seitenwände der Gräben 7 mit einem p-Dotierstoff belegt (Schritt 93). Als p-Dotierstoff wird vorzugsweise Bor eingesetzt. Der Dotierstoff wird vorzugsweise aus der Gasphase in den Gräben 7 abgeschieden oder durch Ionenimplantation in die Gräben 7 eingebracht. Anschließend wird der Diffusionsprozess durchgeführt (Schritt 94), bei dem Bor in die n-Schicht 2 diffundiert und die p-Bereiche 9 bildet. Hierbei ist eine besonders flache p-Diffusion anzustreben. Vorteilhaft kann dies mit der Technik des Rapid Thermal Annealing (RTA) erreicht werden. Abschließend werden wiederum Kontaktschichten 4 und 5 auf Vorder- und Rückseite der Halbleitereinrichtung 40 aufgebracht (Schritt 95).

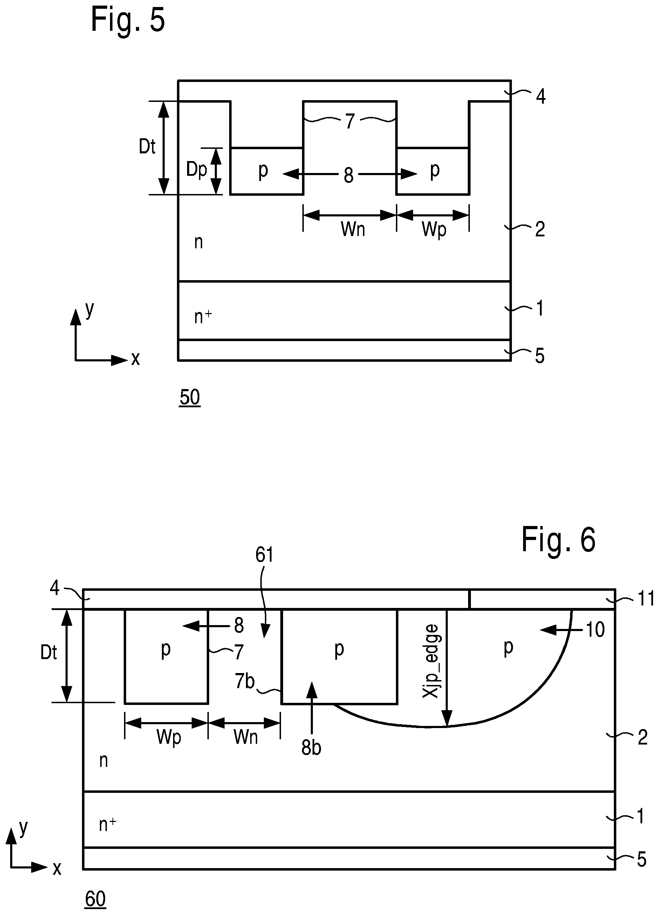

Im Folgenden wird, unter Bezug auf Figur 5, eine Ausführungsvariante der Erfindung beschrieben. Die in Figur 5 dargestellte Halbleitereinrichtung 50 umfasst ein n+-Substrat 1, eine auf diesem Substrat 1 angeordnete n-Schicht 2, sowie mindestens zwei in die n-Schicht 2 eingebrachte Gräben (Trenchs) 7. Die n-Schicht 2 wird wiederum vorzugsweise mittels Epitaxie hergestellt. Die Gräben 7 werden vorzugsweise durch einen Ätzprozess erzeugt. Weiterhin umfasst die Halbleitereinrichtung 50 Kontaktschichten 4,5 an der Vorderseite als Anodenelektrode und an der Rückseite als Kathodenelektrode, die vorzugsweise aus Metall bestehen. Insbesondere die Metallschicht 4 kann auch aus zwei unterschiedlichen, übereinander liegenden Metallschichten bestehen. Bei dieser Ausführungsvariante der Erfindung werden allerdings die Gräben 7, anders als bei der Ausführungsvariante gemäß Figur 3, nur zum Teil, nämlich bis zu einer Dicke Dp, mit p-dotiertem Si oder Poly-Si 8 ausgefüllt, so dass sich die p-Bereiche 8 bilden. Elektrisch gesehen ist diese Ausführungsvariante ebenfalls eine Kombination von PN-Diode (PN-Übergang zwischen den p-dotierten Bereichen 8 als Anode und der n-Schicht 2 als Kathode) und einer Schottky-Diode (Schottky-Barriere zwischen der Kontaktschicht 4 als Anode und der n-Schicht 2 als Kathode). Aber die Schottky-Barriere bildet sich hier sowohl an der Oberfläche der Halbleitereinrichtung 50 als auch an den Seitenwänden des oberen Bereichs der Gräben 7 aus, der nicht mit p-dotiertem Si oder Poly-Si ausgefüllt ist. Ein Vorteil der Halbleitereinrichtung 50 3 ist die niedrigere Flussspannung durch die größere Fläche des Schottky-Kontakts auch an den Seitenwänden des oberen Bereichs der Gräben 7. Allerdings führt dies auch zu einem höheren Sperrstrom, was einen gewissen Nachteil darstellt. In der Praxis bietet diese Ausführungsvariante jedoch die Möglichkeit, die Halbleitereinrichtung 50 durch bedarfsgerechte Einstellung des Parameters Dp nach individuellen Anforderungen bezüglich Flussspannung und Sperrstrom zu optimieren.

Im Folgenden wird ein vorteilhaftes Verfahren zur Herstellung der Halbleitereinrichtung 50 (Ausführungsvariante nach Figur 5) beschrieben, wobei auch auf das Ablaufdiagramm in Figur 10 Bezug genommen wird. Ausgegangen wird wiederum von einem n+-Substrat 1 (Schritt 100), auf das eine n-Schicht 2, vorzugsweise durch Epitaxie, aufgebracht wird (Schritt 101). Durch ein Ätzverfahren werden Gräben 7 in die n-Schicht 2 eingebracht (Schritt 102). Anschließend werden die Gräben 7 mit p-dotiertem Si oder Poly-Si aufgefüllt. In einem nächsten Schritt (103) wird das in die Gräben 7 eingebrachte p-dotierte Si oder Poly-Si wieder teilweise bis auf eine verbleibende Dicke Dp entfernt (Schritt 104). Dies erfolgt zweckmäßig durch einen Ätzprozess. Abschließend werden wiederum Kontaktschichten 4 und 5 auf Vorder- und Rückseite der Halbleitereinrichtung 50 aufgebracht (Schritt 105).

Alle zuvor beschriebenen Beispiele können, im Rahmen einer vorteilhaften Weiterbildung, jeweils in dem Randbereich der Halbleitereinrichtung, noch zusätzliche Strukturen für eine Reduktion der Randfeldstärke umfassen. Diese Strukturen können, beispielsweise aus niedrig dotierten p-Bereichen, Feldplatten oder dergleichen bestehen.

Im Folgenden wird, unter Bezug auf Figur 6, eine weitere, Variante gemäß Figur 3 (Halbleitereinrichtung 30) beschrieben, die zusätzlich mit einer Randstruktur für die Reduktion der Randfeldstärke versehen ist. Die dort dargestellte Halbleitereinrichtung 60 ist durch einen breiten Graben und eine tiefe p-Diffusion an dem Rand der Halbleitereinrichtung ausgezeichnet. Die Halbleitereinrichtung 60 umfasst ein n+-Substrat 1. Auf dem n+-Substrat 1 ist eine n-Schicht 2 angeordnet. In die n-Schicht 2 ist ein zusätzlicher Graben 7b eingebracht. Vorzugsweise werden die Gräben 7, 7b wiederum durch ein Ätzverfahren erzeugt. Wie Figur 6 zeigt, ist der Graben 7b breiter ausgeführt als die Gräben 7. Die Gräben 7, 7b sind mit p-dotiertem Si oder Poly-Si aufgefüllt, so dass sich p-dotierte Bereiche 8,8b in den Gräben 7, 7b ergeben. Unmittelbar an den breiteren Graben 7b schließt sich ein p-dotierter Bereich 10 an. Die der n-Schicht 2 abgewandte Seite des n+-Substrats 1 trägt wiederum eine Kontaktschicht 5. Auf der Vorderseite der Halbleitereinrichtung 60 ist ebenfalls eine Kontaktschicht 4 aufgebracht. Diese Kontaktschicht 4 bedeckt nicht die gesamte Vorderseite der Halbleitereinrichtung. Sie deckt die Gräben 7,7b, die neben den Gräben 7,7b frei liegende n-Schicht 2 und lediglich einen Teil des p-dotierten Bereichs 10 ab. Die verbleibende Vorderseite der Halbleitereinrichtung 60 ist mit einer Oxidschicht 11 bedeckt. Diese Oxidschicht 11 erstreckt sich somit über einen Teil des p-dotierten Bereichs 10 und die rechts daneben frei liegende n-Schicht 2. Um eine höhere Durchbruchspannung am Rand der Halbleitereinrichtung 60 als im Vergleich zum Innenbereich der Halbleitereinrichtung zu erzielen, wird vorteilhaft die Eindringtiefe Xjp_edge des p-dotierten Bereichs 10 größer als die Tiefe Dt der Gräben 7,7b gewählt. Weiterhin werden die Lage des Grabens 7b am Rand der Halbleitereinrichtung 60 und die Lage des p-dotierten Bereichs 10 derart gewählt, dass der eine Randbereich des p-dotierten Bereichs 10 unterhalb des breiteren Grabens 7b endet und den Mesa-Bereich 61 zwischen den Gräben 7,7b nicht mehr berührt. Die Forderung, dass die Eindringtiefe Xjp_edge des p-dotierten Bereichs 10 größer sein soll als die Tiefe Dt der Gräben 7,7b, hat eine gewisse negative Auswirkung auf die Flussspannung, da die n-Schicht 2 entsprechend etwas dicker ausgeführt werden muss. Eine detaillierte Untersuchung hat jedoch gezeigt, dass die Eindringtiefe Xjp_edge des p-dotierten Bereichs 10 nur geringfügig größer als die Tiefe Dt der Gräben 7,7b zu sein braucht, um vorteilhaft eine höhere Durchbruchspannung an dem Rand der Halbleitereinrichtung 60 zu erzielen. So ist die negative Auswirkung des tiefer eingebrachten p-dotierten Bereichs 10 auf die Flussspannung in der Praxis vernachlässigbar klein.

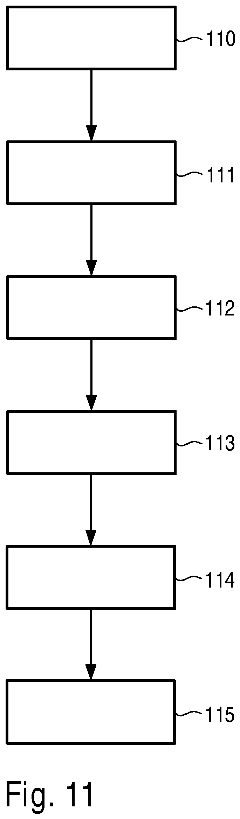

Ein vorteilhaftes Herstellungsverfahren für eine Halbleitereinrichtung 60 wird im Folgenden unter Bezug auf das in Figur 11 dargestellte Ablaufdiagramm beschrieben. Ausgegangen wird wiederum von einem n+-Substrat 1 (Schritt 110), auf das eine n-Schicht 2, vorzugsweise durch Epitaxie, aufgebracht wird (Schritt 111). In einem nächsten Schritt wird mittels einer entsprechend gestalteten Maske auf der Vorderseite durch eine tiefe Diffusion mit einem p-Dotierstoff, wie insbesondere Bor, der p-dotierte Bereich 10 erzeugt (Schritt 112). Dies kann vorteilhaft so erreicht werden, dass ein nicht durch die Maske abgedeckter Bereich der freiliegenden Oberfläche der n-Schicht 2 mit dem p-Dotierstoff belegt wird. Dies kann wiederum durch Abscheiden des Dotierstoffs aus der Gasphase oder durch Ionenimplantation erfolgen. Anschließend diffundiert der Dotierstoff durch Erhitzen in die darunter liegende n-Schicht 2. Durch ein Ätzverfahren werden Gräben 7, 7b in die n-Schicht 2 eingebracht (Schritt 113), wobei der Graben 7b breiter ausgeführt wird als der Graben 7. Anschließend werden die Gräben 7, 7b mit p-dotiertem Si oder Poly-Si aufgefüllt (Schritt 114), so dass sich die p-dotierten Bereiche 8, 8b ergeben. Abschließend werden wiederum Kontaktschichten 4 und 5 auf Vorder- und Rückseite der Halbleitereinrichtung 60 aufgebracht (Schritt 115). Auch hierbei empfiehlt sich eine Maskentechnik, da lediglich ein Teilbereich der Vorderseite der Halbleitereinrichtung 60 mit der Kontaktschicht 4 bedeckt werden soll. Der verbleibende Teil der Oberfläche wird mit der Oxidschicht 11 passiviert.

Im Folgenden wird, unter Bezug auf Figur 7, eine weitere Variante der offenbart. Die in Figur 7 dargestellte Halbleitereinrichtung 70 ist durch einen breiten Graben und eine tiefe p-Diffusion an dem Rand der Halbleitereinrichtung ausgezeichnet, wobei das Diffusionsgebiet bis zu dem Rand der Halbleitereinrichtung 70 reicht. Die Halbleitereinrichtung 70 umfasst ein n+-Substrat 1. Auf dem n+-Substrat 1 ist eine n-Schicht 2 angeordnet. In die n-Schicht 2 sind Gräben 7,7b eingebracht. Vorzugsweise werden die Gräben 7, 7b wiederum durch ein Ätzverfahren erzeugt. Wie Figur 7 zeigt, ist der Graben 7b breiter ausgeführt als die Gräben 7. Die Gräben 7, 7b sind mit p-dotiertem Si oder Poly-Si aufgefüllt, so dass sich p-dotierte Bereiche 8,8b in den Gräben 7, 7b ergeben. Unmittelbar an den breiteren Graben 7b schließt sich ein p-dotierter Bereich 10 an. Die der n-Schicht 2 abgewandte Seite des n+-Substrats 1 trägt wiederum eine Kontaktschicht 5. Auf der Vorderseite der Halbleitereinrichtung 60 ist ebenfalls eine Kontaktschicht 4 aufgebracht. Um eine höhere Durchbruchspannung am Rand der Halbleitereinrichtung 70 als im Vergleich zum Innenbereich der Halbleitereinrichtung zu erzielen, wird vorteilhaft die Eindringtiefe Xjp_edge des p-dotierten Bereichs 10 größer als die Tiefe Dt der Gräben 7,7b gewählt. Weiterhin werden die Lage des Grabens 7b am Rand der Halbleitereinrichtung 60 und die Lage des p-dotierten Bereichs 10 derart gewählt, dass der eine Randbereich des p-dotierten Bereichs 10 unterhalb des breiteren Grabens 7b endet und den Mesa-Bereich 61 zwischen den Gräben 7,7b nicht mehr berührt. Die Forderung, dass die Eindringtiefe Xjp_edge des p-dotierten Bereichs 10 größer sein soll als die Tiefe Dt der Gräben 7,7b, hat eine gewisse negative Auswirkung auf die Flussspannung, da die n-Schicht 2 entsprechend etwas dicker ausgeführt werden muss. Eine detaillierte Untersuchung hat jedoch gezeigt, dass die Eindringtiefe Xjp_edge des p-dotierten Bereichs 10 nur geringfügig größer als die Tiefe Dt der Gräben 7,7b zu sein braucht, um vorteilhaft eine höhere Durchbruchspannung an dem Rand der Halbleitereinrichtung 60 zu erzielen. So ist die negative Auswirkung des tiefer eingebrachten p-dotierten Bereichs 10 auf die Flussspannung in der Praxis vernachlässigbar klein. Der Unterschied zwischen dieser Variante und der in Figur 6 dargestellten Halbleitereinrichtung 60 besteht im Wesentlichen darin, dass hier der p-dotierte Bereich 10 sich bis zu dem Rand der Halbleitereinrichtung 70 erstreckt. Dadurch entsteht zwar ein "offener" PN-Übergang an dem Rand der Halbleitereinrichtung 70, der zu einem höheren Sperrstrom führen kann. Durch eine geeignete Ätztechnik lässt sich jedoch der Sperrstrom deutlich reduzieren. Vorteilhaft bei dieser Ausführungsvariante ist, dass keine Maske für die Anbringung der Kontaktschicht auf der Vorderseite der Halbleitereinrichtung benötigt wird. Weiterhin bietet sich eine besonders günstige Montagemöglichkeit der Halbleitereinrichtung in so genannten Press-Fit-Gehäusen an, da keine empfindlichen Oxide an der Oberfläche der Halbleitereinrichtung 70 vorkommen.

Ein vorteilhaftes Herstellungsverfahren für die Halbleitereinrichtung 70 ähnelt dem schon für die Herstellung der Halbleitereinrichtung 60 beschriebenen Verfahren. Abweichungen ergeben sich lediglich durch eine abgewandelte Maskenstruktur für die Erzeugung des jetzt bis zum Rand reichenden p-dotierten Bereichs 10. Weiterhin ist für das Aufbringen der Kontaktschicht 4 keine Maskierung erforderlich, da die Kontaktschicht 4 die gesamte Vorderfläche der Halbleitereinrichtung 70 abdeckt.

Die unter Bezug auf Figur 6 und Figur 7 beschriebenen Randstrukturen lassen sich, in analoger Weise, vorteilhaft auch bei den unter Bezug auf Figur 4 und Figur 5 beschriebenen Halbleitereinrichtungen anwenden.

Die vorstehend beschriebenen Ausführungsvarianten der erfindungsgemäß ausgestalteten Halbleitereinrichtungen nach Fig. 5 eignet sich vorteilhaft für eine Anwendung als Z-Diode in dem Bordnetz eines Kraftfahrzeugs, insbesondere für den Einsatz in dem Generatorsystem eines Kraftfahrzeugs. Dazu verfügen die Halbleitereinrichtungen zweckmäßig über eine zwischen 12V und 30V, insbesondere zwischen 15V und 25V liegende Durchbruchsspannung. Besonders vorteilhaft sind die Halbleitereinrichtungen im Sperrbetrieb mit einer hohen Stromdichte in der Größenordnung einiger hundert A/cm², insbesondere 400 A/cm² bis etwa 600 A/cm², betreibbar.

### Bezugszeichenliste

- 1: n+-Substrat
- 2: n-dotierte Schicht
- 2.1: Mesa-Bereich
- 61: Mesa-Bereich
- 4: Kontaktschicht
- 5: Kontaktschicht
- 6: Oxidschicht
- 7: Graben
- 7b: Graben
- 8: p-dotierter Bereich
- 8b: p-dotierter Bereich
- 9: p-dotierter Bereich
- 10: p-dotierter Bereich
- 11: Oxidschicht
- 80: Schritt
- 81: Schritt
- 82: Schritt
- 83: Schritt
- 90: Schritt
- 91: Schritt
- 92: Schritt
- 93: Schritt
- 94: Schritt
- 95: Schritt
- 100: Schritt
- 101: Schritt
- 102: Schritt
- 103: Schritt
- 104: Schritt
- 105: Schritt
- 110: Schritt
- 111: Schritt
- 112: Schritt
- 113: Schritt
- 114: Schritt
- 115: Schritt
- BV_mos: Durchbruchsspannung der MOS-Struktur
- BV_pn: Durchbruchsspannung der PN-Diode
- BV_schottky: Durchbruchsspannung der Schottky-Diode
- Dp: Dicke
- Dt0: Tiefe der Gräben
- To: Dicke der Oxidschicht
- Wm: Abstand zwischen den Gräben
- Wn: Abstand zwischen den Gräben
- Wt: Breite der Gräben
- Wp0: Breite der p-Bereiche auf Maske
- Xjp: Eindringtiefe
- Xjp_edge: Eindringtiefe

## Patentansprüche

1. Halbleitereinrichtung (30, 40, 50, 60, 70) mit einer Kombination aus Trench-Junction-Barrier-Schottky-Diode und integrierter PN-Diode, wobei die Durchbruchsspannung (BV_pn) der PN-Diode so ausgelegt ist, dass sie niedriger ist als die Durchbruchsspannung (BV_schottky) der Schottky-Diode, wodurch mittels der PN-Diode eine Klammerfunktion gegeben ist, **dadurch gekennzeichnet, dass** die Halbleitereinrichtung (50) ein n+-Substrat (1) umfasst, dass auf dem n+-Substrat (1) eine n-Schicht (2) angeordnet ist, dass in der n-Schicht (2) mindestens zwei Gräben (7) angeordnet sind, dass die Gräben (7) höchstens teilweise mit einer p-dotierten Substanz angefüllt sind, derart, dass in den Gräben (7) p-dotierte Bereiche (8) der Dicke (Dp) angeordnet sind, die mit der n-Schicht (2) die PN-Diode bilden, und dass das n+-Substrat (1) und die n-Schicht (2) Kontaktschichten (4,5), die aus Metall bestehen, tragen, wobei die Kontaktschicht (4) die Vorderseite der Halbleitereinrichtung (50) vollständig überdeckt und die Gräben (7) vollständig ausfüllt, und auch an den Seitenwänden des oberen Bereichs der Gräben (7), der nicht mit p-dotiertem Si oder Poly-Si ausgefüllt ist, eine Schottky-Barriere bildet.

2. Halbleitereinrichtung nach Anspruch 1, **dadurch gekennzeichnet, dass** diese im Durchbruchbetrieb mit einer hohen Stromdichte in der Größenordnung einiger hundert A/cm², insbesondere 400 A/cm² bis etwa 600 A/cm² betreibbar ist.

3. Halbleitereinrichtung nach einem der vorhergehenden Ansprüche, **dadurch gekennzeichnet, dass** die Kontaktschichten (4,5) mehrschichtig ausgebildet sind.

4. Halbleitereinrichtung nach einem der vorhergehenden Ansprüche, **dadurch gekennzeichnet, dass** sie derart ausgebildet ist, dass im Falle eines Durchbruchs der PN-Diode der Durchbruch vorzugsweise in dem Bereich des Bodens der Gräben (7,7b) stattfindet.

5. Halbleitereinrichtung nach einem der vorhergehenden Ansprüche, **dadurch gekennzeichnet, dass** die Gräben (7) streifen- oder inselförmig ausgebildet sind.

6. Verwendung der Halbleitereinrichtung nach einem der vorhergehenden Ansprüche als Z-Diode und/oder in dem Bordnetz eines Kraftfahrzeugs, insbesondere in dem Generatorsystem eines Kraftfahrzeugs.

7. nach einem der Ansprüche 1 bis 5, **dadurch gekennzeichnet, dass** sie eine Durchbruchsspannung zwischen 10V und 50V, insbesondere zwischen 12V und 40V, aufweist.

## Claims

1. Semiconductor device (30, 40, 50, 60, 70) having a combination of a trench junction barrier Schottky diode and an integrated PN diode, wherein the breakdown voltage (BV_pn) of the PN diode is embodied in such a way that it is lower than the breakdown voltage (BV_schottky) of the Schottky diode, as a result of which a clamping function is given by means of the PN diode, **characterized in that** the semiconductor device (50) comprises an n+-type substrate (1), **in that** an n-type layer (2) is arranged on the n+-type substrate (1), **in that** at least two trenches (7) are arranged in the n-type layer (2), **in that** the trenches (7) are at most partly filled with a p-doped substance in such a way that p-doped regions (8) of thickness (Dp) are arranged in the trenches (7), said p-doped regions together with the n-type layer (2) forming the PN diodes, and **in that** the n+-type substrate (1) and the n-type layer (2) bear contact layers (4, 5), which consist of metal, wherein the contact layer (4) fully covers the front side of the semiconductor device (50) and fully fills the trenches (7), and also forms a Schottky barrier at the side walls of the upper region of the trenches (7) that is not filled with p-doped Si or poly-Si.

2. Semiconductor device according to Claim 1, **characterized in that** it is operable in breakdown operation with a high current density of the order of magnitude of a few hundred A/cm², in particular 400 A/cm² to approximately 600 A/cm².

3. Semiconductor device according to either of the preceding claims, **characterized in that** the contact layers (4, 5) are embodied in multilayered fashion.

4. Semiconductor device according to any of the preceding claims, **characterized in that** it is embodied in such a way that, in the case of a breakdown of the PN diode, the breakdown preferably takes place in the region of the bottom of the trenches (7, 7b).

5. Semiconductor device according to any of the preceding claims, **characterized in that** the trenches (7) are embodied in strip-shaped or insular fashion.

6. Use of the semiconductor device according to any of the preceding claims as a Z diode and/or in the on-board power supply system of a motor vehicle, in particular in the generator system of a motor vehicle.

7. Semiconductor device according to any of Claims 1 to 5, **characterized in that** it has a breakdown voltage of between 10 V and 50 V, in particular between 12 V and 40 V.

## Revendications

1. Dispositif à semi-conducteurs (30, 40, 50, 60, 70) comportant une combinaison constituée d'une diode Schottky à tranchée-jonction-barrière et d'une diode PN intégrée, dans lequel la tension de claquage (BV_pn) de la diode PN est conçue pour être inférieure à la tension de claquage (BV_schottky) de la diode Schottky, assurant ainsi une fonction de blocage par le biais de la diode PN, **caractérisé en ce que** le dispositif à semi-conducteurs (50) comprend un substrat n+ (1), **en ce qu'**une couche n (2) est disposée sur le substrat n+ (1), **en ce qu'**au moins deux tranchées (7) sont disposées dans la couche n (2), **en ce que** les tranchées (7) sont au plus partiellement remplies d'une substance dopée p, de telle sorte que des zones dopées p (8) d'épaisseur (Dp) sont disposées dans les tranchées (7) et forment la diode PN avec la couche n (2), et que le substrat n+ (1) et la couche n (2) portent des couches de contact (4, 5) constituées de métal, dans lequel la couche de contact (4) recouvre entièrement la face avant du dispositif à semi-conducteurs (50) et remplit entièrement les tranchées (7), et qu'elle forme également une barrière Schottky au niveau des parois latérales de la zone supérieure des tranchées (7) qui n'est pas remplie de Si ou de poly-Si dopé p.

2. Dispositif à semi-conducteurs selon la revendication 1, **caractérisé en ce qu'**il est utilisable en mode de claquage avec une densité de courant élevée de l'ordre de quelques centaines d'A/cm², en particulier de 400 A/cm² à environ 600 A/cm².

3. Dispositif à semi-conducteurs selon l'une des revendications précédentes, **caractérisé en ce que** les couches de contact (4, 5) sont réalisées sous forme multicouches.

4. Dispositif à semi-conducteurs selon l'une des revendications précédentes, **caractérisé en ce qu'**il est conçu de telle manière à ce qu'en cas de claquage de la diode PN, le claquage ait lieu de préférence dans la zone du fond des tranchées (7, 7b).

5. Dispositif à semi-conducteurs selon l'une des revendications précédentes, **caractérisé en ce que** les tranchées (7) sont réalisées sous forme de bande ou d'îlot.

6. Utilisation du dispositif à semi-conducteurs selon l'une des revendications précédentes en tant que diode Z et/ou dans le réseau de bord d'un véhicule automobile, en particulier dans le système générateur d'un véhicule automobile.

7. Dispositif à semi-conducteurs selon l'une des revendications 1 à 5, **caractérisé en ce qu'**il présente une tension de claquage comprise entre 10V et 50V, en particulier entre 12V et 40V.
